# EUROPEAN PATENT APPLICATION

(11) **EP 4 835 959 A1**
(43) Date of publication of application: **04.11.2026**
(21) Application number: 24912150.0
(22) Date of filing: 25.11.2024
(51) Int. Cl.: H01L 23/13, C04B 35/587, C04B 37/02, H01L 23/36, H05K 1/03

(54) **CIRCUIT BOARD AND POWER DEVICE**

(30) Priority: 27.12.2023 JP 2023221938
(71) Applicant: Niterra Co., Ltd., Nagoya-shi, Aichi 461-0005 (JP)
(72) Inventor: IKAI, Yoshihito, Nagoya-shi, Aichi 461-0005 (JP); MOTEKI, Jun, Nagoya-shi, Aichi 461-0005 (JP); MITSUOKA, Takeshi, Nagoya-shi, Aichi 461-0005 (JP)
(74) Representative: Grünecker Patent- und Rechtsanwälte PartG mbB
(86) International application number: PCT/JP2024/041675
(87) International publication number: WO 2025/142258

(57) **Abstract**

A circuit board and a power device which have enhanced resistance to thermal cycles while maintaining heat radiation performance are provided. The circuit board 50 includes a ceramic substrate 10 formed of a material containing silicon nitride as a main component, a junction layer 20 formed on a first main face 12 of the ceramic substrate 10 and containing Ti, and a conductor layer 30 joined to the ceramic substrate 10 via the junction layer 20. The thickness of the junction layer 20 is 0.3 µm or greater and 3 µm or less.

## Description

### TECHNICAL FIELD

The present invention relates to a circuit board and a power device.

### BACKGROUND ART

Since silicon nitride has high thermal conductivity and strength, it is attracting attention as a material for insulating heat radiation substrates of power modules for inverters installed in electric vehicles (EVs) and hybrid vehicles (HVs). Conventionally, aluminum nitride has been frequently used as a material for insulating heat radiation substrates. However, in the case of a power module for large current such as that for EVs, since the temperature of the power module rises to about 250°C, there has been a problem that a large thermal stress is generated in its substrate due to the difference in thermal expansion between the substrate and a metal such as copper bonded thereto, and cracking or breakage occurs in the substrate formed of aluminum nitride due to its low strength. Therefore, silicon nitride, which among general insulating ceramic materials is high in thermal conductivity and has higher strength, has been employed in an increasing number of cases, although the thermal conductivity of silicon nitride is lower than that of aluminum nitride. Joining between a silicon nitride heat radiation substrate and a conductor layer has generally been performed by means of brazing in which a brazing material containing a metal is interposed between the substrate and the conductor layer.

Patent Document 1 discloses a ceramic circuit board and a method for manufacturing the ceramic circuit board. The ceramic circuit board has a stress relaxation portion provided on at least one or both of a metal circuit surface and a heat radiation surface and having two or more independent through holes reaching the ceramic substrate, wherein the through hole provided in a straight portion of a circuit pattern satisfies a relation of (0<) h1 ≤ 2D, where h1 is the distance from an end portion of the circuit to an end portion of the through hole, and D is the diameter of the through hole, wherein the spacing (h2) between adjacent through holes satisfies a relation of metal thickness < h2 < 2D, and wherein, in the shape of an end portion of the metal circuit surface, the tangential angle (θ1) of the circuit end portion and the tangential angle (θ2) of the interior of a through hole satisfy a relation of θ2 < θ1 < 90°.

Patent Document 2 discloses a circuit board including a ceramic substrate, a copper circuit plate, and a brazing material projecting portion, wherein the copper circuit plate is joined to at least one face of the ceramic substrate via a brazing material layer containing Ag, Cu, and Ti, wherein the brazing material projecting portion is formed by the brazing material layer that protrudes outward from the side surface of the copper circuit plate, and wherein the total amount of the Ti phase and the TiN phase in the brazing material projecting portion is 3 mass% or greater and differs from the total amount of the Ti phase and the TiN phase in a brazing material layer 4b interposed between the ceramic substrate and the copper circuit plate, and wherein the brazing material projecting portion does not contain or contains one void whose area per void is 200 µm² or less.

### PRIOR ART DOCUMENTS

### PATENT DOCUMENTS

Patent Document 1: JP2013-175525A
Patent Document 2: JP2014-207482A

### SUMMARY OF THE INVENTION

### PROBLEM TO BE SOLVED BY THE INVENTION

In both Patent Document 1 and Patent Document 2, joining between a silicon nitride heat radiation substrate and a conductor layer is performed by means of brazing. In the case where a circuit board is manufactured by joining together a silicon nitride heat radiation substrate and a conductor layer by means of brazing, it is necessary to make the thickness of a brazing material relatively large in order to strongly join together the silicon nitride heat radiation substrate and the conductor layer. However, when the thickness of the brazing material is increased, the thermal conductivity of the brazing portion lowers, and thus, heat radiation performance lowers. Meanwhile, when the thickness of the brazing material is decreased, the possibility of occurrence of interface cracking due to thermal cycles increases.

For this reason, it has been demanded that, in the case where a circuit board formed by joining together a silicon nitride heat radiation substrate and a conductor layer is used as a circuit board of a power device, the circuit board has enhanced resistance to thermal cycles, while maintaining heat radiation performance.

The present invention has been accomplished in view of such circumstances, and its object is to provide a circuit board and a power device which have enhanced resistance to thermal cycles, while maintaining heat radiation performance.

### MEANS FOR SOLVING THE PROBLEM

(1) In order to achieve the above-described object, a circuit board of the present invention has taken the following measures. Namely, a circuit board of an application example of the present invention comprises a ceramic substrate formed of a material containing silicon nitride as a main component, a junction layer formed on a first main face of the ceramic substrate and containing Ti, and a conductor layer joined to the ceramic substrate via the junction layer, wherein the junction layer has a thickness of 0.3 µm or greater and 3 µm or less.
(2) In the circuit board of the application example described in the above paragraph (1), a diffusion layer containing Ti is present in the ceramic substrate on a side toward the junction layer, and the diffusion layer has a thickness of 0.2 µm or greater and 3 µm or less.
(3) In the circuit board of the application example described in the above paragraph (1) or (2), the junction layer contains at least one type of element selected from Si, Cu, and N.
(4) In the circuit board of the application example described in any of the above paragraphs (1) to (3), a second junction layer containing Ti and formed on a second main face of the ceramic substrate located opposite the first main face, and a second conductor layer joined to the ceramic substrate via the second junction layer are further provided, and the second junction layer has a thickness of 0.3 µm or greater and 3 µm or less.
(5) In the circuit board of the application example described in the above paragraph (4), the second conductor layer is joined to a region of the second main face of the ceramic substrate, the region being equal to or greater than 75% of the area of the second main face.
(6) In the circuit board of the application example described in any of the above paragraphs (1) to (5), the conductor layer is formed of a material containing copper as a main component, and the conductor layer has a thickness of 0.2 mm or greater and 1.5 mm or less.
(7) In the circuit board of the application example described in the above paragraph (4) or (5), the thermal conductivity of the circuit board in a direction perpendicular to the first main face is 120 W/mK or greater.
(8) A power device of an application example of the present invention comprises the circuit board described in any of the above paragraphs (1) to (7), and a power semiconductor mounted on the conductor layer.

### EFFECTS OF THE INVENTION

The circuit board and the power device of the present invention can have enhanced resistance to thermal cycles while maintaining heat radiation performance.

### BRIEF DESCRIPTION OF THE DRAWINGS

[FIG. 1] FIG. 1 is a schematic cross-sectional view showing an example of a circuit board according to a first embodiment.
[FIG. 2] FIG. 2 is a schematic plan view showing the example of the circuit board according to the first embodiment.
[FIG. 3] FIG. 3 is an enlarged schematic partial cross-sectional view showing an example of the circuit board according to the first embodiment.
[FIG. 4] FIG. 4 is a schematic cross-sectional view showing an example of a circuit board according to a second embodiment.
[FIG. 5] FIG. 5 is a schematic bottom view showing the example of the circuit board according to the second embodiment.
[FIG. 6] FIG. 6 is an enlarged schematic partial cross-sectional view showing the example of the circuit board according to the second embodiment.
[FIG. 7] FIG. 7 is a schematic cross-sectional view showing an example of a power device according to an embodiment.
[FIG. 8] FIG. 8 is a table showing, for each of circuit boards of examples and a comparative example, thicknesses of layers, thermal conductivity, and results of thermal cycle tests.
[FIG. 9] Section (a) of FIG. 9 is a graph showing the result of SEM-EDX analysis performed on a line AB drawn on a certain SEM image of Example 2, and section (b) of FIG. 9 is a graph showing the result of SEM-EDX analysis performed on a line CD drawn on the SEM image of Example 2.

### MODES FOR CARRYING OUT THE INVENTION

Embodiments of the present invention will now be described with reference to the drawings. In order to facilitate understanding of description, identical constituent elements in the drawings are denoted by the same reference numerals, and their redundant descriptions are omitted. Notably, in structural views, the sizes of constituent elements are conceptually represented and do not necessarily represent the actual dimensional ratios.

### [Configuration of circuit board]

### (First embodiment)

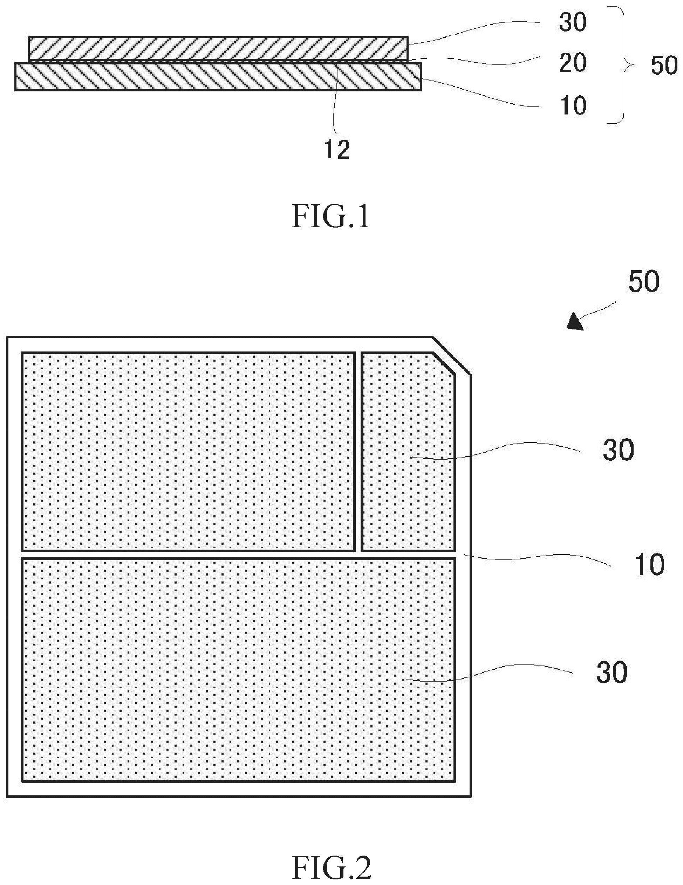

First, a circuit board according to a first embodiment of the present invention will be described. FIG. 1 is a schematic cross-sectional view showing an example of a circuit board 50 according to the first embodiment of the present invention. FIG. 2 is a schematic plan view showing the example of the circuit board 50 according to the first embodiment. The circuit board 50 according to the first embodiment of the present invention includes a ceramic substrate 10, a junction layer 20, and a conductor layer 30.

The ceramic substrate 10 is formed of a material containing silicon nitride as a main component. "Containing silicon nitride as a main component" means that the amount of silicon nitride contained is 86 wt% or greater. The ceramic substrate 10 may contain sialon. The ceramic substrate 10 is formed in the form of a flat plate, for example.

The thickness of the ceramic substrate 10 in a direction perpendicular to its first main face 12 is preferably 220 µm or greater and 690 µm or less. As a result of setting the thickness to fall within this range, the balance between the strength and heat radiation of the ceramic substrate 10 can be improved. When the thickness is less than this range, the strength of the ceramic substrate 10 may lower in some cases. When the thickness is greater than this range, the heat radiation performance may lower in some cases.

The junction layer 20 is formed on the first main face 12 of the ceramic substrate 10. The junction layer 20 contains Ti. The thickness of the junction layer 20 is 0.3 µm or greater and 3 µm or less. As a result of setting the thickness to fall within this range, the heat transfer between the ceramic substrate 10 and the conductor layer 30 is improved, and the heat radiation performance of the circuit board 50 is enhanced.

The thickness of the junction layer 20 can be determined by SEM (scanning electron microscope) observation. Specifically, 5 locations are randomly selected on a polished sectional surface perpendicular to the first main face of the ceramic substrate 10, and, at each location, a view field of 120 µm × 90 µm is observed with a magnification of 2000×. Subsequently, the lengths of 10 lines drawn, at equal intervals, perpendicularly to a line of 100 µm drawn at the interface between the ceramic substrate 10 and the junction layer 20 are obtained. Subsequently the average of these values is calculated as the thickness of the junction layer 20.

The junction layer 20 preferably contains at least one type of element selected from Si, Cu, and N. As a result, the joint strength between the ceramic substrate 10 and the conductor layer 30 increases, and thus, the resistance to thermal cycles increases.

The types of the elements contained in the ceramic substrate 10, the junction layer 20, and the conductor layer 30 can be confirmed by SEM-EDX (scanning electron microscopy energy dispersive X-ray spectroscopy).

The conductor layer 30 is joined to the ceramic substrate 10 via the junction layer 20. The conductor layer 30 is preferably formed of a metal, more preferably formed of a metal containing copper as a main component, further preferably formed of oxygen-free copper. The metal containing copper as a main component refers to a metal containing copper in an amount of 99 wt% or more. The thickness of the conductor layer 30 is preferably 0.2 mm or greater and 1.5 mm or less.

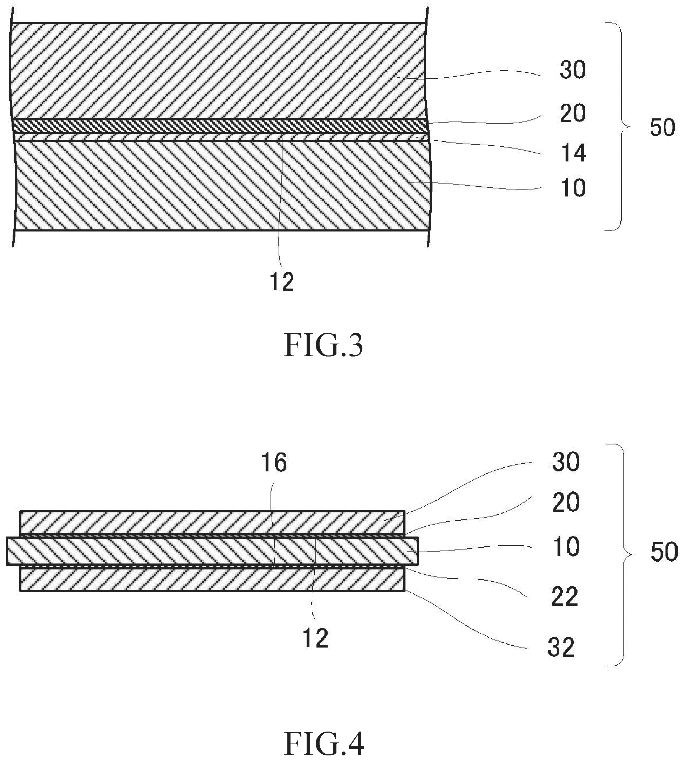

FIG. 3 is an enlarged schematic partial cross-sectional view showing an example of the circuit board 50 according to the first embodiment. It is preferred that, as shown in FIG. 3, a diffusion layer 14 containing Ti is present in the ceramic substrate 10 on a side toward the junction layer 20. The thickness of the diffusion layer 14 is preferably 0.2 µm or greater and 3 µm or less. As a result of setting the thickness to fall within this range, the joint strength between the ceramic substrate 10 and the conductor layer 30 increases, and thus, the resistance to thermal cycles increases.

Presence of the diffusion layer 14 can be confirmed by SEM observation of a cross section of the junction interface between the ceramic substrate 10 and the junction layer 20 of the circuit board 50. The thickness of the diffusion layer 14 can be obtained by performing SEM-EDX analysis on lines set on an SEM image of the cross section. Specifically, 5 locations are randomly selected on a polished sectional surface perpendicular to the first main face of the ceramic substrate 10, and, at each location, a view field of 120 µm × 90 µm is observed with a magnification of 2000×. Subsequently, two or more lines perpendicular to a straight line drawn at the interface between the ceramic substrate 10 and the junction layer 20 are set on the SEM image. The lines are preferably at equal intervals. Subsequently, line analysis is performed by SEM-EDX on the set lines, thereby obtaining a region of the ceramic substrate 10 into which Ti is diffused. The diffusion layer 14 is considered to extend from the interface between the ceramic substrate 10 and the junction layer 20 to a point at which the count number of Ti obtained by the line analysis first becomes less than one tenth of the maximum value of the count number of Ti of the junction layer 20 obtained by the line analysis. Subsequently, the lengths of the obtained regions along the lines are measured. The average of these values is calculated as the thickness of the diffusion layer 14. The lines set for obtaining the thickness of the diffusion layer 14 may be line segments obtained by extending some of the 10 line segments set for obtaining the thickness of the junction layer 20.

### (Second embodiment)

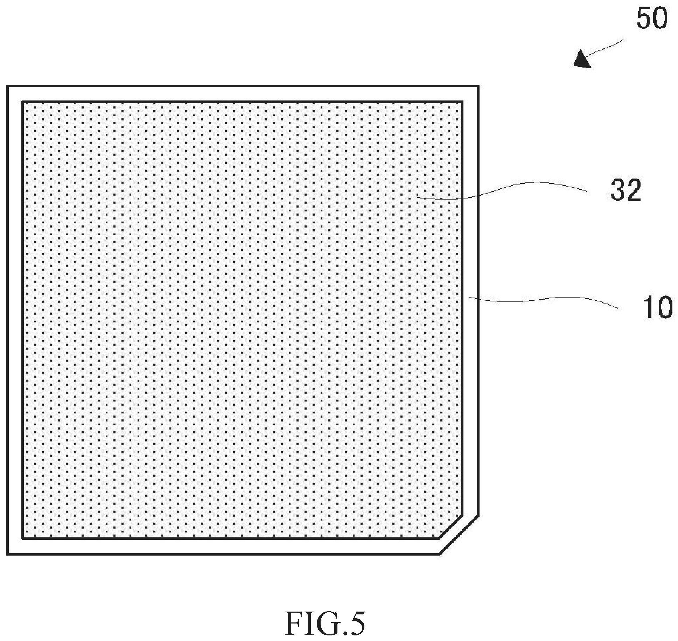

Next, a circuit board according to a second embodiment of the present invention will be described. Since many portions of a circuit board 50 according to the second embodiment are identical to those of the circuit board 50 according to the first embodiment, only portions different from those of the circuit board 50 according to the first embodiment will be described. FIG. 4 is a schematic cross-sectional view showing an example of the circuit board 50 according to the second embodiment of the present invention. FIG. 5 is a schematic bottom view showing the example of the circuit board 50 according to the second embodiment. The circuit board 50 according to the second embodiment of the present invention includes a ceramic substrate 10, a junction layer 20, a conductor layer 30, a second junction layer 22, and a second conductor layer 32. The configurations of the ceramic substrate 10, the junction layer 20, and the conductor layer 30 are the same as those of the circuit board 50 according to the first embodiment.

The second junction layer 22 is formed on a second main face 16 of the ceramic substrate 10 located opposite the first main face 12. The second junction layer 22 preferably contains Ti. The thickness of the second junction layer 22 is preferably 0.3 µm or greater and 3 µm or less. As a result of setting the thickness to fall within this range, the heat transfer between the ceramic substrate 10 and the second conductor layer 32 is improved, and the heat radiation performance of the circuit board 50 is enhanced. The method of obtaining the thickness of the second junction layer 22 is the same as the method of obtaining the thickness of the junction layer 20. The thickness of the second junction layer 22 may be equal to or may differ from the thickness of the junction layer 20.

The second junction layer 22 preferably contains at least one type of element selected from Si, Cu, and N. As a result, the joint strength between the ceramic substrate 10 and the second conductor layer 32 increases, and thus, the resistance to thermal cycles increases. The type of the elements contained in the second junction layer 22 can be confirmed by SEM-EDX.

The second conductor layer 32 is joined to the ceramic substrate 10 via the second junction layer 22. The second conductor layer 32 is preferably formed of a metal, more preferably formed of a metal containing copper as a main component, further preferably formed of oxygen-free copper. Although the material of the second conductor layer 32 may differ from the material of the conductor layer 30, the material of the second conductor layer 32 is preferably the same as the material of the conductor layer 30. The thickness of the second conductor layer 32 is preferably 0.2 mm or greater and 1.5 mm or less. The thickness of the second conductor layer 32 may be equal to or may differ from the thickness of the conductor layer 30.

As shown in FIG. 5, the second conductor layer 32 is preferably joined to a region of the second main face 16 of the ceramic substrate 10, the region being 75% or more of the area of the second main face 16. As a result, heat can be radiated efficiently from the second conductor layer 32, whereby the heat radiation performance of the circuit board 50 is enhanced.

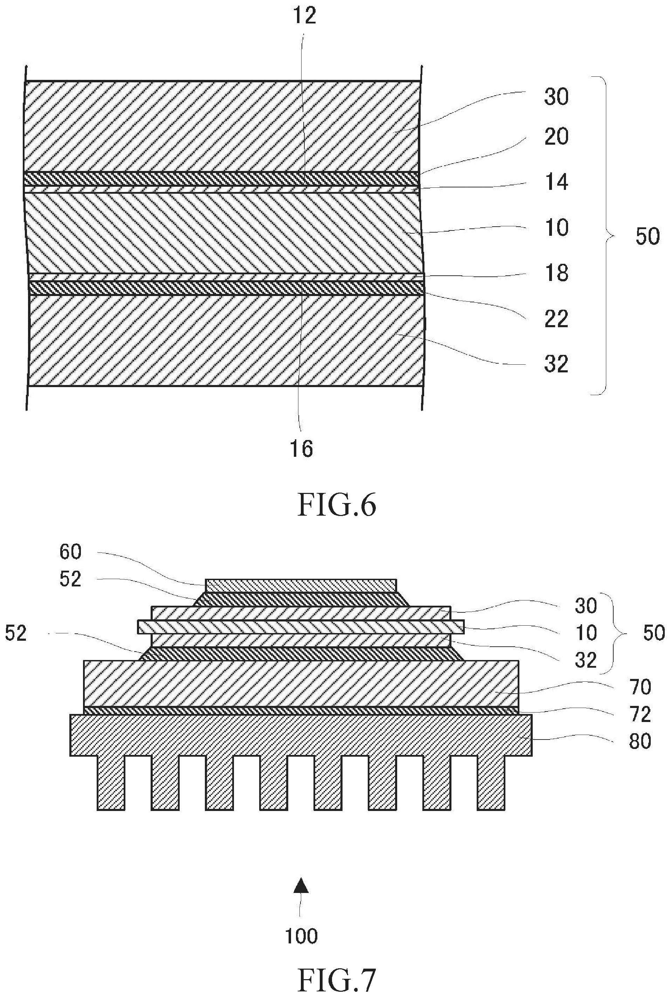

FIG. 6 is an enlarged schematic partial cross-sectional view showing the example of the circuit board 50 according to the second embodiment. It is preferred that a second diffusion layer 18 containing Ti is present in the ceramic substrate 10 on a side toward the second junction layer 22. The thickness of the second diffusion layer 18 is preferably 0.2 µm or greater and 3 µm or less. As a result of setting the thickness to fall within this range, the joint strength between the ceramic substrate 10 and the second conductor layer 32 increases. The thickness of the second diffusion layer 18 may be equal to or may differ from the thickness of the diffusion layer 14.

Presence of the second diffusion layer 18 can be confirmed by SEM observation of a cross section of the joint interface between the ceramic substrate 10 and the second junction layer 22 of the circuit board 50. As in the method of obtaining the thickness of the junction layer 20, the thickness of the second diffusion layer 18 can be obtained by performing SEM-EDX analysis on lines set on an SEM image of the cross section.

The thermal conductivity of the circuit board 50 in a direction perpendicular to the first main face 12 is preferably 120 W/mK or greater. As a result of this, the heat radiation performance of the circuit board 50 becomes sufficiently high. Notably, the thermal conductivity of the circuit board 50 in the direction perpendicular to the first main face 12 is measured for the circuit board 50 including the conductor layer 30 and the second conductor layer 32 such as the circuit board 50 according to the second embodiment.

The thermal conductivity of the circuit board 50 in the direction perpendicular to the first main face 12 can be measured and calculated by the laser flash method.

By virtue of these characteristics, the circuit board 50 can have enhanced resistance to thermal cycles while maintaining heat radiation performance.

### [Configuration of power device]

FIG. 7 is a schematic cross-sectional view showing an example of a power device according to an embodiment of the present invention. The power device 100 includes a circuit board 50 and a power semiconductor 60. In FIG. 7, the junction layer 20, the second junction layer 22, etc. of the circuit board 50 are not shown.

The circuit board 50 is the above-described circuit board 50. In the circuit board 50, the conductor layer 30 is formed at least on the first main face 12 of the ceramic substrate 10. In the circuit board 50, the second conductor layer 32 may be formed on the second main face 16 located opposite the first main face 12.

The power semiconductor 60 is mounted on the upper side of the conductor layer 30 of the circuit board 50. The power semiconductor 60 may be joined to the conductor layer 30 by using solder 52 or the like. The power semiconductor 60 may be, for example, a semiconductor for EVs through which large current flows and whose temperature is likely to become high. The circuit board 50 of the present invention has enhanced resistance to thermal cycles while maintaining heat radiation performance, because, even when the high temperature causes generation of a large thermal stress in the ceramic substrate 10 due to the difference in thermal expansion between the ceramic substrate 10 and a metal joined thereto, cracking or breakage is less likely to occur.

In the case where the circuit board 50 includes the second conductor layer 32, a heat radiation plate 70 may be joined to the lower side of the second conductor layer 32. The heat radiation plate 70 may be joined to the second conductor layer 32 by using solder 52 or the like.

A surface of the heat radiation plate 70 located opposite a surface thereof which is joined to the second conductor layer 32 may be in contact with a heat radiation member 80 via grease 72 or the like. The heat radiation plate 70 is preferably formed of a metal, more preferably formed of a metal containing copper as a main component, further preferably formed of oxygen-free copper. The heat radiation member 80 preferably has heat radiation fins. The heat radiation member 80 is preferably formed of a metal, more preferably formed of a metal containing copper or aluminum as a main component.

### [Method for manufacturing circuit board]

One example of a method for manufacturing the above-described circuit board is shown below. A general silicon nitride sintered body can be used for the ceramic substrate. The silicon nitride sintered body can be manufactured by, for example, a method described below. First, raw material powders of the silicon nitride sintered body are weighed. The raw material powders of the silicon nitride sintered body may be oxides, carbonates, hydroxides, nitrides, etc. of the elements contained in the silicon nitride sintered body. Examples of the raw material powders of the silicon nitride sintered body include magnesium carbonate, calcium carbonate, and yttrium oxide, in addition to silicon nitride.

These raw material powders with ethanol added thereto are mixed and pulverized in a wet condition by a ball mill for 6 to 60 hours, for example, thereby obtaining a slurry. The slurry is dried by heating it in hot water or by using a spray dryer, whereby a mixed powder is obtained.

Next, the mixed powder is injected into a mold and molded into a desired shape by performing a uniaxial press at a pressure of, for example, 30 MPa. Subsequently, a CIP process (cold isostatic molding process) is performed at a pressure of, for example, 150 MPa, whereby a compact is obtained. The obtained compact (CIP pressed body) is placed in, for example, a mold which is formed of silicon carbide and whose interior is coated with BN, and is fired in a nitrogen atmosphere of 9 atm for 5 to 30 hours, while a maximum temperature of 1800°C to 1900°C is held, whereby a silicon nitride sintered body is obtained.

External machining is performed for the obtained silicon nitride sintered body such that the silicon nitride sintered body has a predetermined shape and a predetermined thickness, whereby the ceramic substrate is manufactured. Examples of the machining include cutting, grinding, polishing, etc. The main surface of the ceramic substrate to which the conductor layer is joined is preferably polished such that the surface roughness Ra of the main face becomes 0.5 µm or less.

Separately from the manufacture of the ceramic substrate, a plate having a predetermined thickness and serving as the conductor layer is prepared. The plate is preferably formed of a metal, more preferably formed of a metal containing copper as a main component, further preferably formed of oxygen-free copper. Subsequently, a metal film containing Ti and serving as the junction layer is formed on the plate or the first main face of the ceramic substrate. The metal film can be formed by means of vapor deposition, sputtering, plating, or the like. The thickness of the metal film is preferably 0.3 µm or greater and 3 µm or less. In the case where a metal foil as thin as the metal film can be prepared, formation of the metal film is not necessary.

Next, the plate with the metal film formed thereon and the ceramic substrate are stacked such that the metal film is sandwiched therebetween. In the case where the metal film is not formed, the plate, the metal foil, and the ceramic substrate are stacked in this order. Subsequently, an HP process (hot pressing process) or an HIP process (hot isostatic pressing process) is performed for the stack, whereby the plate and the ceramic substrate can be joined together. The conditions of the HP process are, for example, such that the pressure is 5 MPa or higher and 30 MPa or lower, the maximum temperature is 700°C or higher and 980°C or lower, and the maximum temperature holding time is 10 minutes or longer and 2 hours or shorter.

By the manufacturing method as described above, a circuit board which has enhanced resistance to thermal cycles while maintaining heat radiation performance can be manufactured.

### [Examples and Comparative example]

### (Example 1)

Silicon nitride powder (average particle size: 1.4 µm), magnesium carbonate powder (average particle size: 2.5 µm), and yttrium oxide powder (average particle size: 1.0 µm) were weighed such that their amounts became 94 wt%, 3 wt%, and 3 wt%, respectively. Next, the weighed raw material powders were subjected to ball milling, whereby a mixed slurry was obtained. The ball milling was performed in such a manner that the raw material powders and ethanol were put into a resin pot, and the raw material powders were pulverized and mixed at 60 rpm for 24 hours by using balls formed of silicon nitride. The obtained mixed slurry was dried by heating it in hot water, thereby obtaining a mixed powder.

A compact was made from the obtained mixed powder by performing powder press molding by a uniaxial press and a CIP process. First, the mixed powder was injected into a dedicated mold, and preliminary molding was performed at a pressure of 30 MPa by the uniaxial press. Subsequently, the intermediate product obtained as a result of the preliminary molding was put into a dedicated bag which was then evacuated, and CIP molding was performed at a pressure of 150 MPa. The obtained compact was fired. The method of sintering was atmosphere firing in which a gas pressure of 9 atm was created by nitrogen and a maximum temperature of 1900°C was held for 10 hours. A mold which was formed of silicon carbide and whose interior was coated with BN was used. A silicon nitride sintered body obtained through firing was cut into a piece having a size of 100 mm × 100 mm × 0.32 mm, and a surface of the piece to which a conductor layer is to be joined was polished such that the surface roughness Ra becomes 0.5 µm or less. Thus, the ceramic substrate was prepared.

Separately from the ceramic substrate, two plates each having a size of 100 mm × 100 mm × 0.3 mm and formed of oxygen-free copper were prepared. Subsequently, Ti for forming a junction layer was vapor-deposited to a thickness of 0.3 µm on the surfaces of the plates, which surfaces are to be joined to the ceramic substrate. In this manner, two conductor layers were prepared. Subsequently, one conductor layer, the ceramic substrate, the other conductor layer (the second conductor layer) were stacked in this order and were joined together by performing the HP process (hot pressing process). The pressure was set to 10 MPa, the maximum temperature was set to 900°C, and the maximum temperature holding time was set to 30 minutes. In this manner, a circuit board of Example 1 was produced.

### (Example 2)

A circuit board of Example 2 was produced under the same conditions as the circuit board of Example 1 except that the thickness of Ti vapor-deposited on each plate was set to 0.5 µm.

### (Example 3)

A circuit board of Example 3 was produced under the same conditions as the circuit board of Example 1 except that the thickness of Ti vapor-deposited on each plate was set to 1 µm.

### (Example 4)

A circuit board of Example 4 was produced under the same conditions as the circuit board of Example 1 except that the thickness of Ti vapor-deposited on each plate was set to 2 µm.

### (Example 5)

A circuit board of Example 5 was produced under the same conditions as the circuit board of Example 1 except that the thickness of Ti vapor-deposited on each plate was set to 3 µm.

### (Comparative example 1)

A circuit board of Comparative example 1 was produced under the same conditions as the circuit board of Example 1 except that Ti was not vapor-deposited on each plate, and a brazing material containing Ti, Cu, and Ag was applied to a thickness of 15 µm, and the joining was performed by heating to 800°C.

### [Various measurements]

The obtained circuit boards of the examples and the comparative example were evaluated by the following measurements, etc.

### (Calculation of thermal conductivity)

The thermal conductivities of the circuit boards of the examples and the comparative example were obtained at room temperature by the laser flash method.

### (Thermal cycle test)

Each of the circuit boards of the examples and the comparative example was placed in a thermal cycle tester, and the following thermal cycle test was performed. In the thermal cycle test, a cycle of -40°C (30 minutes) → 25°C (10 minutes) → 130°C (30 minutes) → 25°C (10 minutes) → -40°C (cooling) was repeated 500 times, and then each circuit board was observed. A circuit board in which blistering of the conductor layer or the second conductor layer, or cracking of the ceramic substrate was not observed was determined to be acceptable (O), and a circuit board in which blistering of the conductor layer or the second conductor layer, or cracking of the ceramic substrate was observed was determined to be unacceptable (X).

### (Confirmation of diffusion layer)

Each circuit board was cut perpendicularly to the first main face of the ceramic substrate, and its cut surface was polished. Then, presence of the diffusion layer was confirmed by observing an SEM image (2000x) of the cut surface.

### (Measurement of elements contained in layers)

Each circuit board was cut perpendicularly to the first main face of the ceramic substrate, and its cut surface was polished. Subsequently, SEM images (2000x) of the cut surface were captured at 5 locations. Subsequently, on each SEM image, a straight line was drawn along the interface between the ceramic substrate and the junction layer, and two lines perpendicular to the straight line were set. The distance between the two lines was set to about 4 µm. Then, the types and relative amounts of the elements contained in each layer were determined by performing analysis on the lines by SEM-EDX.

### (Results)

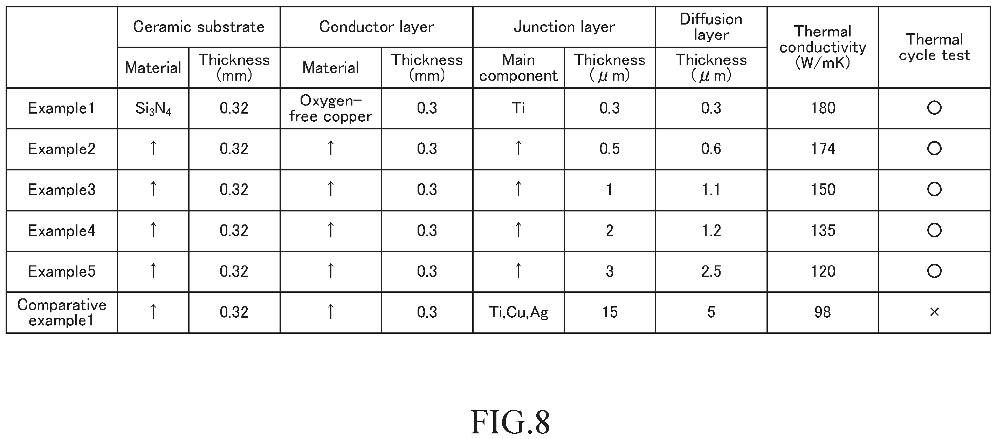

FIG. 8 is a table which shows, for each of the circuit boards of the examples and the comparative example, the thicknesses of the respective layers, thermal conductivity, and results of thermal cycle tests. Examples 1 to 5, in which the thickness of the junction layer was 0.3 µm or greater and 3 µm or less were high in thermal conductivity and their results of the thermal cycle test were acceptable. In contrast, Comparative example 1, in which a conventional brazing material was used for joining, and the thickness of the junction layer was large, was low in thermal conductivity and its result of the thermal cycle test was unacceptable. These show that it is preferred that the thickness of the junction layer is 0.3 µm or greater and 3 µm or less.

Since the ceramic substrate, the junction layer, and the conductor layer differed from each other in color tone on each SEM image observed, they were able to be clearly distinguished from one another. In addition, the fact that a diffusion layer is formed on the ceramic substrate side of the interface between the ceramic substrate and the junction layer and the fact that the diffusion layer can be distinguished from the remaining portion of the ceramic substrate which is not the diffusion layer were able to be confirmed by the SEM-EDX analysis described below. Therefore, the thickness of the diffusion layer was calculated from the result of the SEM-EDX analysis.

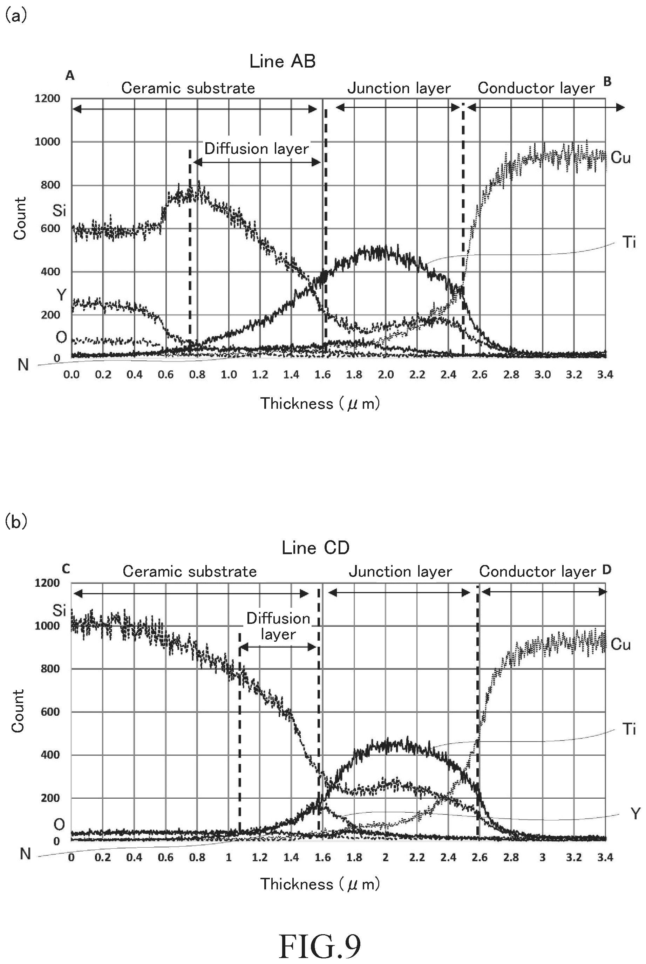

Section (a) of FIG. 9 is a graph showing the result of SEM-EDX analysis performed on a line AB drawn on a certain SEM image of Example 2, and section (b) of FIG. 9 is a graph showing the result of SEM-EDX analysis performed on a line CD drawn on the SEM image of Example 2. Broken lines in sections (a) and (b) of FIG. 9, which show the interface between the ceramic substrate and the junction layer and the interface between the junction layer and the conductor layer, represent the positions of the interfaces observed on the SEM image. As shown in sections (a) and (b) of FIG. 9, it was confirmed that Ti was diffused toward the ceramic substrate side from the junction layer interface observed on the SEM image. As a result, it was found that the diffusion layer of the ceramic substrate contains Ti. The length of a region into which Ti was diffused was measured from the interface between the ceramic substrate and the junction layer along 10 lines on each of five images, and the average of the measured lengths was calculated as the thickness of the diffusion layer. In addition, it was found that the junction layer contains Si, Cu, or N, although their amounts vary depending on the distances from the ceramic substrate and the conductor layer.

As described above, in the circuit board of the present invention, since the junction layer is sufficiently thin, and a diffusion layer is formed in the ceramic substrate, presumably, the joint strength between the ceramic substrate and the conductor layer increases, which makes it possible to increase the resistance to thermal cycles while maintaining heat radiation performance.

It was confirmed from the above results that the circuit board and the power device of the present invention can have enhanced resistance to thermal cycles while maintaining heat radiation performance.

Needless to say, the present invention is not limited to the above-described embodiments and encompasses various modifications and equivalents included in the idea and scope of the present invention. In addition, the structures, shapes, numbers, positions, sizes, etc. of the constituent elements shown in the drawings are for the convenience of description and may be changed as appropriate.

### DESCRIPTION OF REFERENCE NUMERALS

10: ceramic substrate
12: first main face
14: diffusion layer
16: second main face
18: second diffusion layer
20: junction layer
22: second junction layer
30: conductor layer
32: second conductor layer
50: circuit board
52: solder
60: power semiconductor
70: heat radiation plate
72: grease
80: heat radiation member
100: power device

## Claims

1. A circuit board **characterized by** comprising:
a ceramic substrate formed of a material containing silicon nitride as a main component;
a junction layer formed on a first main face of the ceramic substrate and containing Ti; and
a conductor layer joined to the ceramic substrate via the junction layer,
wherein the junction layer has a thickness of 0.3 µm or greater and 3 µm or less.

2. The circuit board according to claim 1, wherein a diffusion layer containing Ti is present in the ceramic substrate on a side toward the junction layer, and
the diffusion layer has a thickness of 0.2 µm or greater and 3 µm or less.

3. The circuit board according to claim 1 or 2, wherein the junction layer contains at least one type of element selected from Si, Cu, and N.

4. The circuit board according to claim 1 or 2, further comprising:
a second junction layer containing Ti and formed on a second main face of the ceramic substrate located opposite the first main face; and
a second conductor layer joined to the ceramic substrate via the second junction layer,
wherein the second junction layer has a thickness of 0.3 µm or greater and 3 µm or less.

5. The circuit board according to claim 4, wherein the second conductor layer is joined to a region of the second main face of the ceramic substrate, the region being equal to or greater than 75% of the area of the second main face.

6. The circuit board according to claim 1 or 2, wherein the conductor layer is formed of a material containing copper as a main component, and the conductor layer has a thickness of 0.2 mm or greater and 1.5 mm or less.

7. The circuit board according to claim 4, wherein the thermal conductivity of the circuit board in a direction perpendicular to the first main face is 120 W/mK or greater.

8. A power device **characterized by** comprising:
the circuit board according to claim 1 or 2; and
a power semiconductor mounted on the conductor layer.
